# EUROPEAN PATENT SPECIFICATION

(11) **EP 1 794 640 B1**
(45) Date of publication and mention of the grant of the patent: **26.02.2014**
(21) Application number: 05781237.2
(22) Date of filing: 18.08.2005
(51) Int. Cl.: G02B 27/14, H01L 33/00, F21V 7/00, F21V 7/05

(54) **ILLUMINATION SYSTEM**
BELEUCHTUNGSSYSTEME
SYSTEME D'ECLAIRAGE

(30) Priority: 24.09.2004 EP 04104642
(43) Date of publication of application: 13.06.2007
(73) Proprietor: Koninklijke Philips N.V., 5656 AE Eindhoven (NL)
(72) Inventor: HOELEN, Christoph, G., A., NL-5656 AA Eindhoven (NL); ANSEMS, Johannes, P., M., NL-5656 AA Eindhoven (NL)
(74) Representative: Damen, Daniel Martijn
(86) International application number: PCT/IB2005/052724
(87) International publication number: WO 2006/033032

(56) References cited:
- WO-A-2005/050710
- US-A- 5 255 171
- US-A1- 2002 080 622
- US-A1- 2004 174 706
- US-B1- 6 200 002

## Description

The invention relates to an illumination system comprising a light source with a plurality of light emitters, a facetted light-collimator and a facetted light-reflector.

Such illumination systems are known per se. They are used, inter alia, for general lighting purposes, such as spot lights, accent lighting, flood lights and for large-area direct-view light emitting panels such as applied, for instance, in signage, contour lighting, and billboards. In other applications, the light emitted by such illumination systems is fed into a light guide, optical fiber or other beam-shaping optics. In addition, such illumination systems are used as backlighting of (image) display devices, for example for television receivers and monitors. Such illumination systems can be used as a backlight for non-emissive displays, such as liquid crystal display devices, also referred to as LCD panels, which are used in (portable) computers or (cordless) telephones. Another application area of the illumination system according to the invention is the use as illumination source in a digital projector or so-called beamer for projecting images or displaying a television program, a film, a video program or a DVD, or the like.

Generally, such illumination systems comprise a multiplicity of light emitters, for instance light-emitting diodes (LEDs). LEDs can be light sources of distinct primary colors, such as, for example the well-known red (R), green (G), or blue (B) light emitters. In addition, the light emitter can have, for example, amber (A), magenta or cyan as primary color. These primary colors may be either generated directly by the light-emitting-diode chip, or may be generated by a phosphor upon irradiance with light from the light-emitting-diode chip. In the latter case, also mixed colors or white light is possible as one of the primary colors. Generally, the light emitted by the light emitters is mixed in the transparent element(s) to obtain a uniform distribution of the light while eliminating the correlation of the light emitted by the illumination system to a specific light emitter. In addition, it is known to employ a controller with a sensor and some feedback algorithm in order to obtain high color accuracy and/or luminous flux accuracy.

US patent application publication US-A 2002/0080622 describes an illumination device including an array of light-emitting diodes (LEDs) in each of a plurality of colors such as red, green, and blue in the entrance aperture of a tubular reflector which has an exit aperture, an optic axis extending between the apertures, and a reflective circumferential wall extending between the apertures to reflect and mix light from the array of LEDs. At least a portion of the circumferential wall of the reflector body has a polygonal cross-section taken normal to the optic axis, and at least a portion of the cross-section taken parallel to the optic axis includes segments of a curve joined on to the next to form a plurality of facets for reflecting light from the LEDs to said exit aperture.

A drawback of the known illumination system is that the light emitted by the illumination system is not sufficiently uniform.

The invention has for its object to eliminate the above disadvantage wholly or partly. According to the invention, this objective is achieved by an illumination system comprising
a light source with a plurality of light emitters,
the light emitters comprising at least a first light emitting diode of a first primary color and at least a second light emitting diode of a second primary color, the first and the second primary colors being distinct from each other,
a facetted light-collimator for collimating light emitted by the light emitters,
the facetted light-collimator being arranged along a longitudinal axis of the illumination system,
the facetted light-collimator merging into a facetted light-reflector at a side facing away from the light source,
a light-shaping diffuser,
CHARACTERIZED IN THAT
light propagation in the facetted light-collimator being based on total internal reflection or on reflection at a reflective coating provided on the facets of the facetted light-collimator, and
the number of facets of the facetted light-collimator or of the facetted light-reflector double from a side facing the light emitters towards a side facing away of the light emitters.

By combining a light source comprising a set of differently colored light emitters with a facetted light-collimator that uses total internal reflection (TIR) to collimate the light, a facetted light-reflector and a light-shaping diffuser, an illumination system is obtained with a uniform spatial and spatio-angular color distribution of the light emitted by the light emitters. The light-collimator is facetted to optimally mix the various colors emitted by the light emitters. In addition, the facetted light-reflector, acting as a second-stage reflector, is employed to further shape the beam of light emitted by the illumination system. This has the advantage of minimizing the volume and weight of the illumination system. The light-shaping diffuser further promotes the spatial mixing of the light emitted by the light emitters.

By basing the propagation of light in the facetted light-collimator on total internal reflection (TIR), light losses in the facetted light-collimator are largely avoided. The distribution of light emitted by the illumination system according to the invention is substantially uniform. Depending on the dimensions of the illumination system, the light emitted by the illumination system is substantially mixed in a spatial as well as in an angular manner. In addition, the light emitted by the illumination system is substantially collimated (paralleled). Preferably, the facetted light-collimator is made of a non-gaseous, optically transparent dielectric material. Preferably, the facetted light-collimator is made from a dielectric material with a refractive index larger than or equal to 1.3.

A preferred embodiment of the illumination system according to the invention is characterized in that the light emitters or clusters of light emitters are arranged in the light source such that the light emitters or clusters of light emitters of each primary color are preferably distributed as evenly as possible over the effective light source area, where the effective light source area is defined as the smallest circular area comprising all the light emitters. In the preferred embodiment, the light emitters of each primary color have their center of gravity on the optical axis of the illumination system. In addition, the light emitters or clusters of light emitters are arranged in the light source such that the primary colors are distributed substantially rotationally symmetric with respect to a fictitious plane normal to the longitudinal axis. In this manner the light emitters or clusters of light emitters of each primary color located at approximately the same distance from the optical axis are distributed as much as possible over an angular range of 360° in a fictitious plane perpendicular to the optical axis. By having a relatively high rotational symmetry in the layout of the light emitters in the light source, the color homogeneity of the light emitted by the illumination system is substantially improved. The higher the degree of rotational symmetry in the placement of the light emitters in the light source, the diffusiveness of the light-shaping diffuser can be relatively low thereby optimizing the system efficiency of the illumination system. There are many ways in which an almost perfect rotational symmetric placement of the light emitters around the longitudinal axis is obtained. In a number of cases it is not possible to have a perfect rotational symmetry of the light emitters; in such case, conditions for the placement of the light emitters are sought approaching the desired rotational symmetry as good as possible.

The facetted light-collimator for collimating light emitted by the light emitters can be realized in various ways. Preferably, the facetted light-collimator has a polygonal circumference in a cross section taken normal to the longitudinal axis consisting of 4 to 10 segments. In order to stimulate the formation of a substantially round light beam emitted by the illumination system, it is advantageous to increase the number of facets of the light-collimator along the longitudinal axis. To this end a preferred embodiment of the illumination system according to the invention is characterized in that the number of facets of the facetted light-collimator doubles from a side facing the light emitters towards a side of the facetted light-collimator facing away of the light emitters. In a favorable embodiment of the illumination system, the facetted light-collimator has a hexagonal cross-section taken normal to the longitudinal axis and the facetted light reflector has a hexagonal cross section taken normal to the longitudinal axis at a side facing the light emitters and has a dodecagonal cross-section at a side of the facetted light-reflector facing away of the light emitters. In this embodiment of the illumination system, at each joint of the segments of the polygonal circumference of a cross section of the facetted reflector taken normal to the optical axis at the side facing the light emitters tri-angular facets start such that at any other cross section of the facetted reflector taken normal to the optical axis the circumference is dodecagonal. In this way all facets are essentially planar facets, thereby promoting homogenization the light in the beam emitted from the lighting system by so-called facet-spreading. In another favorable embodiment of the illumination system, the facetted light-collimator comprises contiguous, linear trapezoidal facets. Normally, each trapezoid is inclined with respect to the longitudinal axis by an angle.

A preferred embodiment of the illumination system according to the invention is characterized in that the facets of the facetted light-collimator are provided with a reflective coating. This allows for steeper angles of the facetted light-collimator enabling smaller dimensions for the light-reflector and eventually leading to smaller dimensions of the illumination system. Preferably, also the facetted light-reflector comprises contiguous, linear trapezoidal facets.

In order to reduce light losses in the illumination system, a preferred embodiment of the illumination system according to the invention is characterized in that the facetted light-collimator is provided with cavities for accommodating the light emitters, the cavities being provided with an encapsulant substantially matching the refractive index of the facetted light-collimator. In order to enhance the light extraction from the light emitters in the illumination system, in a preferred embodiment of the illumination system, the cavities in the light collimator accommodating the light emitters are provided with an encapsulant with an index of refraction that is substantially higher than that of the facetted light collimator. In this case the volume of the cavity is enlarged and/or the shape is adapted to prevent total internal reflection at the interface between the encapsulant and the facetted light collimator.

The light-shaping diffuser can be provided at various places in the illumination system. To be effective, a certain distance between the light emitters and the light-shaping diffuser is desired. To this end a preferred embodiment of the illumination system according to the invention is characterized in that the light-shaping diffuser is provided at a distance from the light source, the distance being at least twice the effective diameter of the light source. The light-shaping diffuser particularly promotes small-angle diffusion of the light passing through the light-shaping diffuser. By placing the light-shaping diffuser at two times or, more preferred, three times the effective diameter of the light source, the color homogeneity of the light emitted by the illumination system is substantially stimulated. With the effective diameter of the light source is meant the diameter of the smallest circle comprising all light emitters. In keeping with the above consideration, the light-shaping diffuser is preferably, provided at an exit window of the facetted light-collimator or at an exit window of the facetted light-reflector.

Preferably, the light shaping diffuser is integrated or in optical contact with the facetted light collimator to prevent reflection losses that would occur at the additional interfaces.

Preferably, the light-shaping diffuser is a holographic diffuser. Preferably, the holographic diffuser is a randomized holographic diffuser. The primary effect of the holographic diffuser is that a uniform spatial and angular color and light distribution is obtained. By the nature of the holographic diffuser, the dimensions of the holographic diffuser, or beam shaper, are so small that no details are projected on a target, thus resulting in a spatially and/or angularly smoothly varying, homogeneous beam pattern. A secondary effect of a holographic diffuser is the causing of a change in the shape of the light beam emitted by the illumination system.

These and other aspects of the invention are apparent from and will be elucidated with reference to the embodiments described hereinafter.

In the drawings:
Figure 1A is an exploded view of a first embodiment of the illumination system according to the invention;
Figure 1B is the embodiment of the illumination system as shown in Figure 1A in assembled form;
Figure 2A is a cross-sectional view of a combination of a facetted light-collimator and a facetted light-reflector with five levels of facets;
Figure 2B is a top view of a combination of a facetted light-collimator and a facetted light-reflector as shown in Figure 2A with eight circumferential segments,
Figure 2C is a top view of a combination of a facetted light-collimator with six segments and a facetted light-reflector starting with six segments and ending with twelve segments;
Figure 3A-3F show examples of favorable configurations of light emitters in the light source, and
Figure 4 shows a composite lighting system comprising multiple illumination systems according to the invention.

The Figures are purely diagrammatic and not drawn to scale. Notably, some dimensions are shown in a strongly exaggerated form for the sake of clarity. Similar components in the Figures are denoted as much as possible by the same reference numerals.

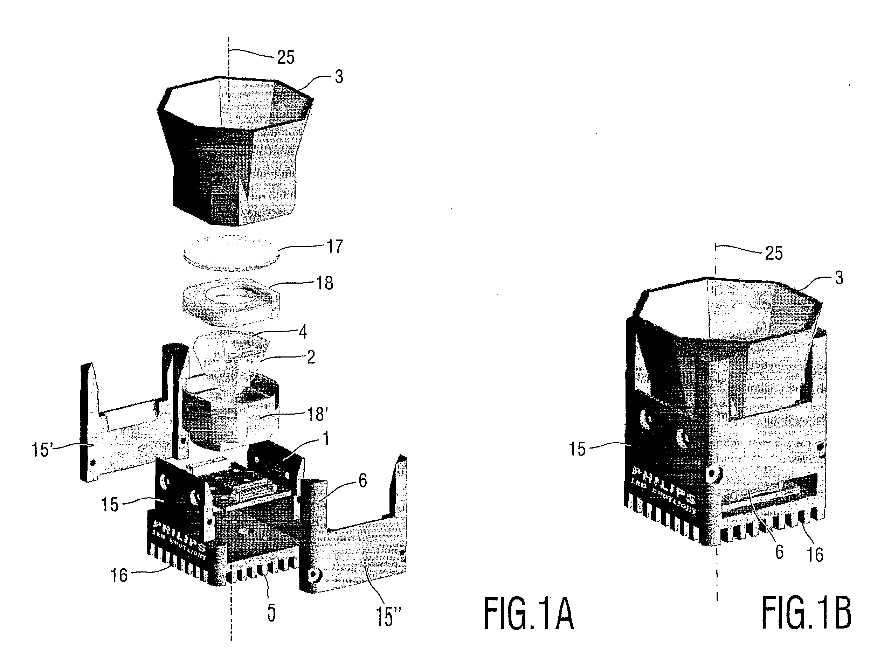

Figure 1A very schematically shows an exploded view of a first embodiment of the illumination system according to the invention; Figure 1B very schematically shows the embodiment of the illumination system as shown in Figure 1 in assembled form. A very compact illumination system is obtained. The illumination system comprises a light source 1 comprising a plurality of light emitters R, G, B of distinct primary color. Preferably, the light emitters are light-emitting diodes (LEDs). LEDs can be light emitters of distinct primary colors, such as, for example, the well-known red R, green G, or blue B light emitters. Preferably, the light emitters comprise at least a first light-emitting diode R of a first primary color, at least a second light-emitting diode G of a second primary color, and at least a third light-emitting diode B of a third primary color, the three primary colors being distinct from each other. Alternatively, the light emitter can have, for example, amber, magenta or cyan as primary color. The primary colors may be either generated directly by the light-emitting-diode chip, or may be generated by a phosphor upon irradiance with light from the light-emitting-diode chip. In the latter case, also mixed colors or white light is possible as one of the primary colors. Alternatively, the illumination system can be provided with a plurality of light emitters with only two primary colors, for instance a combination of white and yellow or amber light emitters.

In the example of Figure 1A, the light emitters R, G, B are mounted on a substrate, in this case a (metal core) printed circuit board 5, providing electrical connection to the LEDs and serving as heat conductor to spread and transport the heat away from the light emitters. Such a substrate can be, for example, an insulated metal substrate such as a metal core printed circuit board, a silicon or ceramic substrate provided with the electrical leads and appropriate electrode patterns for connecting the LEDs, or substrates from composite materials such as carbon fiber reinforced metal substrates.

In general, light-emitting diodes have relatively high source brightness. Preferably, each of the LEDs has a radiant power output of at least 25 mW when driven at nominal power and at room temperature. LEDs having such a high output are also referred to as LED power packages. The use of such high-efficiency, high-output LEDs has the specific advantage that, at a desired, comparatively high light output, the number of LEDs may be comparatively small. This has a positive effect on the compactness and the efficiency of the illumination system to be manufactured. If LED power packages are mounted on such a (metal-core) printed circuit board (PCB) 5, the heat generated by the LEDs can be readily dissipated by heat conduction via the PCB. A connector 6 provides electrical contact of the light emitters R, G, B to a power supply (not shown in Figure 1A) of the illumination system.

In a favorable embodiment of the illumination system, the (metal-core) printed circuit board 5 is in contact with a housing 15, 15', 15" of the illumination system via a heat-conducting connection. The housing 15, 15', 15" acts as heat sink for the light emitters R, G, B, and also as a heat exchanger between the ambient and the light emitters R, G, B. Preferably, so-called power LED chips are mounted on a substrate, such as for instance an insulated metal substrate, a silicon substrate, a diamond substrate, ceramic or a composite substrate such as a metal matrix composite substrate. The printed circuit board 5 provides electrical connection to the LED chip and acts as well as a good heat transportation section to transfer heat to a heat exchanger 16.

The embodiment of the illumination system as shown in Figure 1A is rotational symmetric around a longitudinal axis 25 and comprises a facetted light-collimator 2 for collimating light emitted by the light emitters R, G, B arranged along the longitudinal axis. Light propagation in the facetted light-collimator 2 is based on total internal reflection (TIR) towards a light-exit window 4 of the facetted light-collimator 2. Preferably, the facetted light-collimator 2 is made of a non-gaseous, optically transparent dielectric material. Preferably, the facetted light-collimator 2 is made of a dielectric material with a refractive index larger than or equal to 1.3, for instance glass, polycarbonate (PC), or polymethylmethacrylate (PMMA). The PMMA optic is e.g. made by optical milling and glued to a support means 18. Preferably, the PMMA optic is made by injection molding. Preferably, the facetted PMMA light collimator 2 and the support means 18 are made as a single integrated product. This support means 18 is fitted into a further support means 18' and mounted on the on the printed circuit board 5 with encapsulant between the LEDs and the PMMA. In this manner, each of the light emitters R, G, B is in optical contact with the facetted light-collimator 2 thereby reducing light losses in the illumination system. The support means 18, 18' simplify the assembly of the illumination system (see Figure 1B).

The illumination system as shown in Figure 1A may comprise a light sensor (not shown in Figure 1 A) for optical feedback. Preferably, the light sensor is positioned in the housing 15, 15', 15" and mounted on the printed circuit board 5. This simplifies assembling the illumination system. The light sensor is connected to a controller (not shown in Figure 1A) for controlling the electrical current of the light emitters R, G, B in response to the light received by the light sensor. The light sensor or photo diode is placed next to the TIR collimator 2 to detect the amount of flux emitted by the LEDs. Preferably, time resolved detection is used, which is synchronized with the pulse-width modulated driving of the LED chips. This is particularly helpful in case of an illumination system with a variety of primary colors enabling the measurement of the flux for each primary color individually and independently. In a preferred embodiment, several light sensors are placed around the facetted collimator to increase the accuracy of the measurement of the average light levels of the primary colors, or combinations of primary colors, being emitted.

The embodiment of the illumination system as shown in Figure 1A further comprises a facetted reflector 3 rotational symmetric around a longitudinal axis 25. This reflector 3 further collimates the beam of light emitted by the illumination system. The reflector 3 is facetted for further shaping and for further homogenizing the light beam emitted by the illumination system. In an alternative embodiment, the reflector is substantially shaped according to a compound parabolic concentrator (CPC). In an alternative embodiment, the shape of the facetted light-collimator is similar to but not exactly the shape of a compound parabolic concentrator. The reflector 3 is filled with air and the inner walls of the reflector 3 are made reflective or coated with a (specular) reflective coating. Preferably, the facetted light-reflector 3 comprises contiguous, linear trapezoidal facets.

The embodiment of the illumination system as shown in Figure 1A further comprises the illumination system comprising a light-shaping diffuser 17. In the example of Figure 1A, the light-shaping diffuser is a randomized holographic diffuser. The holographic diffuser stimulates spatial and angular color mixing of the light resulting in a spatially and/or angularly smoothly varying, homogeneous beam pattern. In addition, the holographic diffuser causes a change in the shape of the light beam emitted by the illumination system.

Preferably, the light-shaping diffuser 17 is provided at a distance from the light source 1, the distance being at least twice the effective diameter of the light source 1. In the example of Figure 1A, the light-shaping diffuser 17 is provided at an exit window 4 of the facetted light-collimator 2. In an alternative embodiment, the light-shaping diffuser 17 is provided at an exit window of the facetted light-reflector.

The illumination system may either be a spot or flood module in which the TIR collimator is at least partly facetted and more or less rotationally symmetric, or a linear light source in which the TIR collimator is a linear structure. The embodiment of the illumination system as shown in Figure 1B in assembled form is a very compact LED spot module for general lighting purpose. The embodiment of the illumination system as shown in Figure 1B is a very compact illumination system (LED spot module) with a relatively high uniform spatial and spatio-angular color distribution of the light emitted by the light emitters.

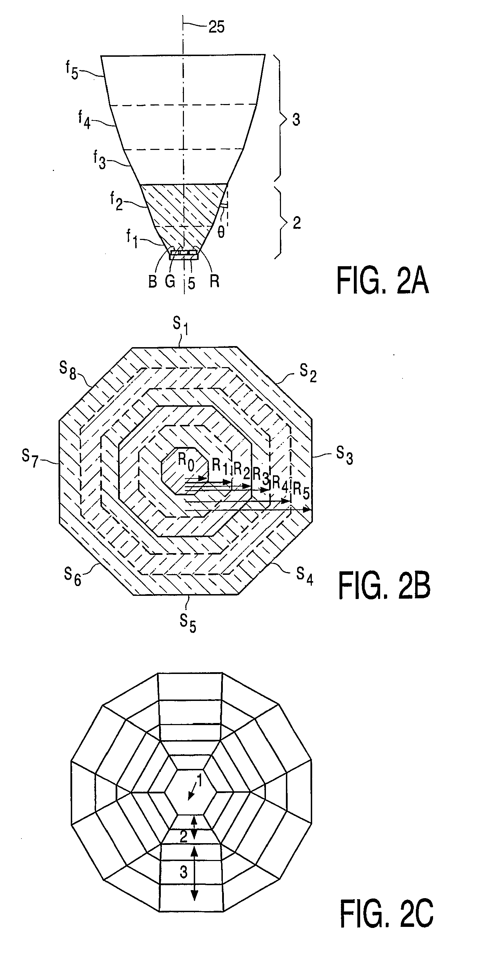

Figure 2A schematically show a cross-sectional view of a combination of a facetted light-collimator 2 and a facetted light-reflector 3 with in total five facets referenced f₁, f₂, f₃, f₄, and f₅ with respective radii R₀, R₁, R₂, R₃, R₄, R₅ (see Figure 2B; the surface area defined by R₀ is, preferably, large enough to accommodate all light emitters in the light source). The angle of the facets is indicated by the angle θ. The longitudinal axis 25 is indicated in Figure 2A. The light emitters R, G, B are mounted on a metal-core printed circuit board 5. Figure 2B schematically shows a top view (normal to the longitudinal axis 25) of the combination of a facetted light-collimator 2 and a facetted light-reflector 3 as shown in Figure 2A with eight segments referenced S₁, S₂, S₃, S₄, S₅, S₆, S₇ and S₈. Table I gives an example of the radii R and angles θ of the light-collimator 2 and light-reflector 3 as shown in Figure 2A and 2B.

**Table I Typical dimensions of a light-collimator 2 and light-reflector 3 as shown in Figure 2A and 2B**

| | | radius (mm) | angle θ (°) |
|---|---|---|---|
| light source | | 3.2 | |
| | | Start End | |
| light collimator | facet 1 | 8.0 | 37 |
| | facet 2 | 11.4 | 20.5 |
| light reflector | facet 3 | 14.6 | 27 |
| | facet 4 | 18.4 | 17.5 |
| | facet 5 | 20.9 | 12.5 |

Figure 2C schematically shows a top view of a combination of a facetted light-collimator 2 with six segments and a facetted light-reflector 3 starting with six segments and ending with twelve segments. Preferably, the facetted light-collimator 2 has a polygonal cross-section (see Figure 2B) taken normal to the longitudinal axis 25 that consists of 4 to 10 segments. Figure 2B shows the configuration in which both the facetted light collimator 2 and the facetted light reflector 3 have an octagonal cross section taken normal to the optical axis 25. In the embodiment of Figure 2C the formation of a substantially round light beam emitted by the illumination system is stimulated by increasing the number of facets of the light-reflector 3 along the longitudinal axis 25. In the example of Figure 2C, the number of facets of the facetted light-reflector 3 doubles from a side facing the light source 1 towards a side facing away of the light source 1. In the example of Figure 2C, the facetted light-reflector 2 has a hexagonal cross-section taken normal to the longitudinal axis 25 at a side facing the light source 1 and has a dodecagonal cross-section at a side facing away of the light emitters. In this embodiment of the illumination system, each of the facets of the hexagonal cross-section is split into two facets, thereby obtaining a dodecagonal cross-section of the facetted light-reflector. In an alternative embodiment the number of facets of the light-collimator is increased along the longitudinal axis.

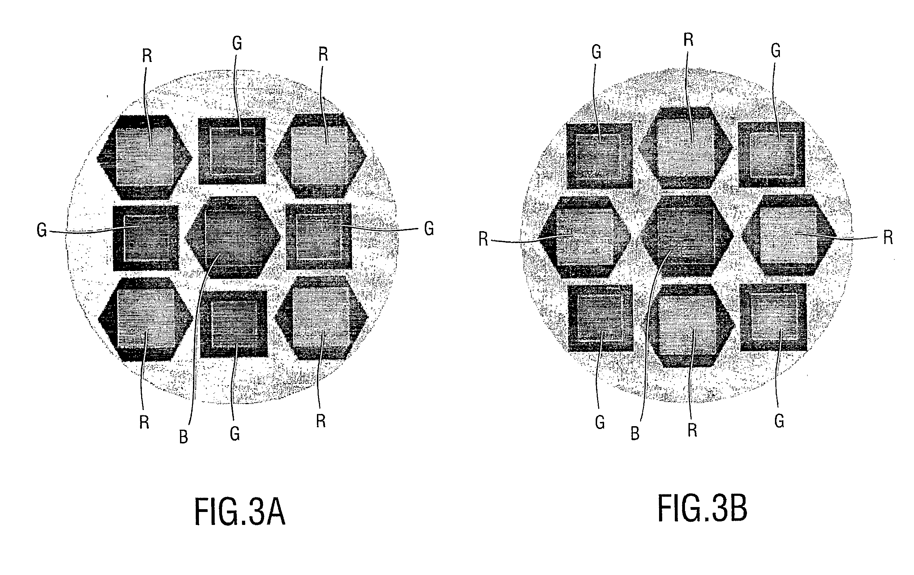

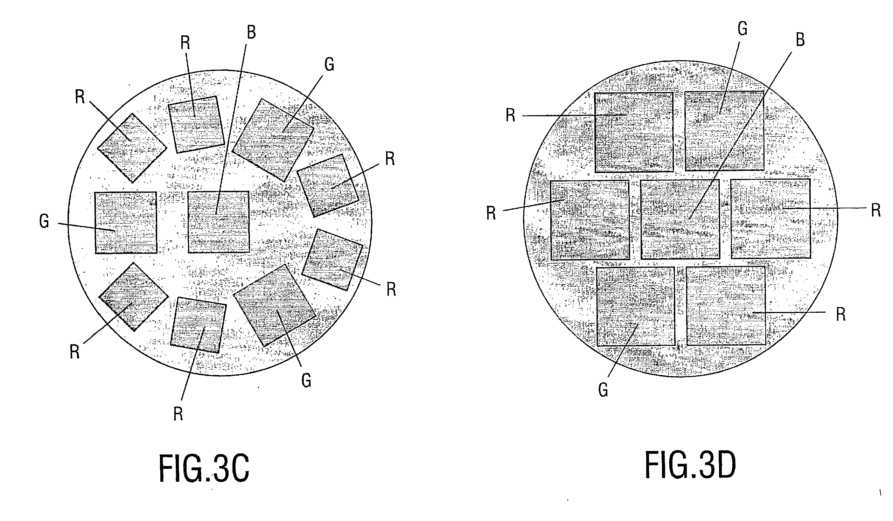

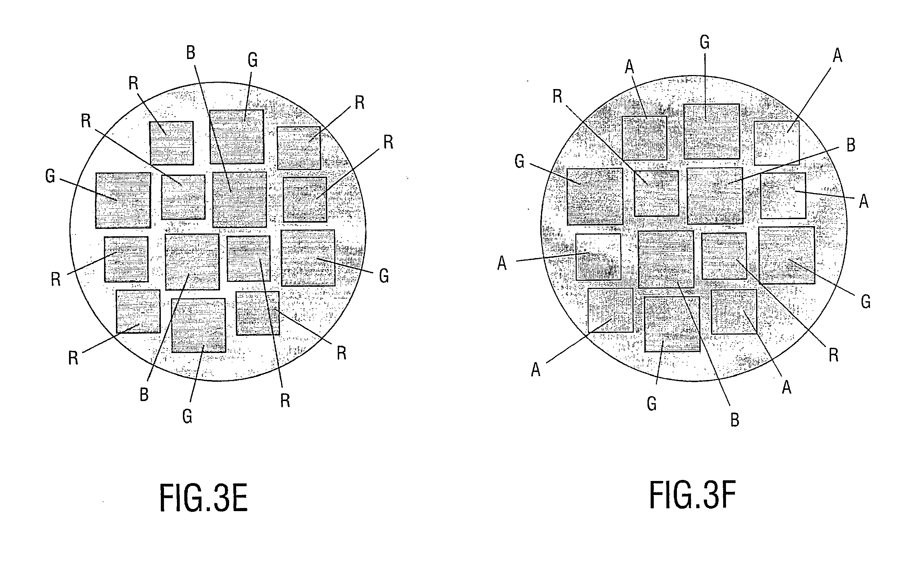

Figure 3A-3F schematically show examples of favorable configurations of light emitters in the light source. The maximum dimension of both configurations is 6 mm in diameter. Each of the examples comprises 9 LEDs with a 4:4: 1 chip ratio for the respective colors R, G and B. This configuration depends on the efficacy of the respective LEDs and can be suitably adapted. In the examples as shown in Figure 3A and 3B, the light emitters R, G, B are arranged in the light source 1 such that the primary colors are distributed substantially rotationally symmetric with respect to a fictitious plane normal to the longitudinal axis 25 (see Figures 1A and 1B). By having a relatively high rotational symmetry in the layout of the light emitters R, G, B in the light source 1, the color homogeneity of the light emitted by the illumination system is substantially improved. The higher the degree of rotational symmetry in the placement of the light emitters R, G, B in the light source 1, the diffusiveness of the light-shaping diffuser 17 can be relatively low thereby further optimizing the system efficiency of the illumination system.

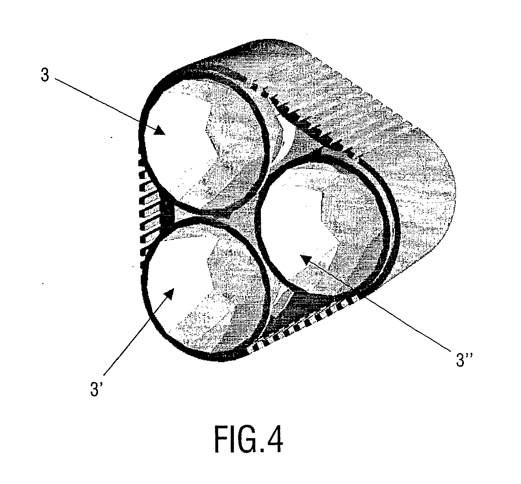

Figure 4 very schematically shows a composite lighting system comprising multiple illumination systems according to the invention. In Figure 4 the facetted reflectors of each of the lighting systems are referenced 3, 3', 3". Preferably, the composite lighting system is provided with a common heat spreader, housing, and electrical interface to power and control the composite lighting system.

It should be noted that the above-mentioned embodiments illustrate rather than limit the invention, and that those skilled in the art will be able to design many alternative embodiments without departing from the scope of the appended claims.

## Claims

1. An illumination system comprising
- a light source (1) with a plurality of light emitters (R,G,B),
- the light emitters (R,G,B) comprising at least a first light emitting diode (R) of a first primary color and at least a second light emitting diode (G) of a second primary color, the first and the second primary colors being distinct from each other,
- a facetted light-collimator (2) for collimating light emitted by the light emitters (R,G,B), the facetted light-collimator (2) being arranged along a longitudinal axis (25) of the illumination system,
- the facetted light-collimator (2) merging into a facetted light-reflector (3) at a side facing away from the light source (1),
- a light-shaping diffuser (7), **CHARACTERIZED IN THAT**
- light propagation in the facetted light-collimator (2) being based on total internal reflection or on reflection at a reflective coating provided on the facets of the facetted light-collimator (2), and
- the number of facets of the facetted light-collimator (2) or of the facetted light-reflector (3) double from a side facing the light emitters towards a side facing away of the light emitters.

2. An illumination system as claimed in claim 1, wherein the light emitters (R,G,B) are arranged in the light source (1) such that the primary colors are distributed substantially rotationally symmetric with respect to a fictitious plane normal to the longitudinal axis (25).

3. An illumination system as claimed in claim 1 or 2, wherein the facetted light-collimator (2) is made from a dielectric material with a refractive index larger than or equal to 1.3.

4. An illumination system as claimed in claim 1 or 2, wherein the number of circumferential facets of the facetted light-collimator (2) taken normal to the longitudinal axis (25) at a side facing the light emitters (R,G,B) is between 4 and 10.

5. An illumination system as claimed in claim 4, wherein the facetted light-collimator (2) has a hexagonal or octagonal cross-section taken normal to the longitudinal axis (25) at a side facing the light emitters (R,G,B).

6. An illumination system as claimed in claim 1 or 2, wherein the facets of the facetted light-collimator (2) are provided with a reflective coating.

7. An illumination system as claimed in claim 1 or 2, wherein the facetted light-collimator (2) comprises contiguous, linear trapezoidal facets.

8. An illumination system as claimed in claim 1 or 2, wherein the facteted light collimator (2) is provided with cavities for accommodating the light emitters (R,G,B), the cavities being provided with an encapsulant substantially matching the refractive index the facetted light-collimator (2).

9. An illumination system as claimed in claim 1 or 2, wherein the facetted light-reflector (3) comprises contiguous, linear trapezoidal facets.

10. An illumination system as claimed in claim 1 or 2, wherein the light-shaping diffuser (17) is provided at a distance from the light source (1), the distance being at least twice the effective diameter of the light source (1).

11. An illumination system as claimed in claim 9, wherein the light-shaping diffuser (17) is provided at an exit window (4) of the facetted light-collimator (2) or at an exit window of the facetted light-reflector (3).

12. An illumination system as claimed in claim 10, wherein the light-shaping diffuser (17) is a holographic diffuser.

13. An illumination system as claimed in claim 1 or 2, wherein the light emitters further comprise at least a third light-emitting diode (B) of a third primary color, the three primary colors being distinct from each other.

14. An illumination system as claimed in claim 1 or 2, wherein each of the light-emitting diodes (R,G,B) has a radiant power output of at least 25 mW when driven at nominal power and at room temperature.

## Patentansprüche

1. Beleuchtungssystem mit:
- einer Lichtquelle (1) mit mehreren Lichtemittern (R,G,B),
- wobei die Lichtemitter (R,G,B) mindestens eine erste, Licht emittierende Diode (R) einer ersten Primärfarbe und mindestens eine zweite, Licht emittierende Diode (G) einer zweiten Primärfarbe umfassen, wobei sich die erste und die zweite Primärfarbe voneinander unterscheiden,
- einem facettierten Lichtkollimator (2), um von den Lichtemittern (R,G,B) emittiertes Licht zu kollimieren, wobei der facettierte Lichtkollimator (2) entlang einer Längsachse (25) des Beleuchtungssystems angeordnet ist,
- wobei der facettierte Lichtkollimator (2) auf einer von der Lichtquelle (1) abgewandten Seite in einen facettierten Lichtreflektor (3) übergeht,
- einem Lichtformungsdiffusor (7), **dadurch gekennzeichnet, dass**
- Lichtausbreitung in dem facettierten Lichtkollimator (2) auf innerer Totalreflexion oder einer Reflexion an einer auf den Facetten des facettierten Lichtkollimators (2) vorgesehenen, reflektiven Beschichtung basiert, und
- die Anzahl von Facetten des facettierten Lichtkollimators (2) oder des facettierten Lichtreflektors (3) sich von einer den Lichtemittern zugewandten Seite zu einer von den Lichtemittern abgewandten Seite hin verdoppelt.

2. Beleuchtungssystem nach Anspruch 1, wobei die Lichtemitter (R,G,B) in der Lichtquelle (1) so angeordnet sind, dass die Primärfarben gegenüber einer fiktiven Ebene senkrecht zu der Längsachse (25) im Wesentlichen rotationssymmetrisch verteilt sind.

3. Beleuchtungssystem nach Anspruch 1 oder 2, wobei der facettierte Lichtkollimator (2) aus einem dielektrischen Material mit einem Brechungsindex größer als oder gleich 1,3 gefertigt ist.

4. Beleuchtungssystem nach Anspruch 1 oder 2, wobei die Anzahl umlaufender Facetten des facettierten Lichtkollimators (2) senkrecht zu der Längsachse (25) auf einer den Lichtemittern (R,G,B) zugewandten Seite zwischen 4 und 10 liegt.

5. Beleuchtungssystem nach Anspruch 4, wobei der facettierte Lichtkollimator (2) einen hexagonalen oder oktagonalen Querschnitt senkrecht zu der Längsachse (25) auf einer den Lichtemittern (R,G,B) zugewandten Seite hat.

6. Beleuchtungssystem nach Anspruch 1 oder 2, wobei die Facetten des facettierten Lichtkollimators (2) mit einer reflektiven Beschichtung versehen sind.

7. Beleuchtungssystem nach Anspruch 1 oder 2, wobei der facettierte Lichtkollimator (2) unmittelbar aufeinanderfolgende, lineare, trapezförmige Facetten umfasst.

8. Beleuchtungssystem nach Anspruch 1 oder 2, wobei der facettierte Lichtkollimator (2) mit Hohlräumen zur Aufnahme der Lichtemitter (R,G,B) versehen ist, wobei die Hohlräume mit einem Einkapselungsmaterial versehen sind, das dem Brechungsindex des facettierten Lichtkollimators (2) im Wesentlichen entspricht.

9. Beleuchtungssystem nach Anspruch 1 oder 2, wobei der facettierte Lichtreflektor (3) unmittelbar aufeinanderfolgende, lineare, trapezförmige Facetten umfasst.

10. Beleuchtungssystem nach Anspruch 1 oder 2, wobei der Lichtformungsdiffusor (17) in einem Abstand von der Lichtquelle (1) vorgesehen ist, wobei der Abstand mindestens zweimal den effektiven Durchmesser der Lichtquelle (1) ausmacht.

11. Beleuchtungssystem nach Anspruch 9, wobei der Lichtformungsdiffusor (17) an einem Austrittsfenster (4) des facettierten Lichtkollimators (2) oder an einem Austrittsfenster des facettierten Lichtreflektors (3) vorgesehen ist.

12. Beleuchtungssystem nach Anspruch 10, wobei der Lichtformungsdiffusor (17) ein holographischer Diffusor ist.

13. Beleuchtungssystem nach Anspruch 1 oder 2, wobei die Lichtemitter weiterhin zumindest eine dritte, Licht emittierende Diode (B) einer dritten Primärfarbe umfassen, wobei sich die drei Primärfarben voneinander unterscheiden.

14. Beleuchtungssystem nach Anspruch 1 oder 2, wobei jede der Licht emittierenden Dioden (R,G,B) eine Strahlungsleistungsabgabe von mindestens 25 mW aufweist, wenn diese bei Nennleistung und bei Raumtemperatur angesteuert wird.

## Revendications

1. Système d'éclairage, comprenant :
- une source lumineuse (1) avec une pluralité d'émetteurs de lumière (R, G, B),
- les émetteurs de lumière (R, G, B) comprenant au moins une première diode électroluminescente (R) d'une première couleur primaire et au moins une deuxième diode électroluminescente (G) d'une deuxième couleur primaire, les première et deuxième couleurs primaires étant distinctes l'une de l'autre,
- un collimateur de lumière à facettes (2) pour collimater la lumière émise par les émetteurs de lumière (R, G, B), le collimateur de lumière à facettes (2) étant agencé le long d'un axe longitudinal (25) du système d'éclairage,
- le collimateur de lumière à facettes (2) se fusionnant en un réflecteur de lumière à facettes (3) sur un côté orienté dans une direction opposée à la source lumineuse (1),
- un diffuseur de mise en forme de lumière (7), **caractérisé en ce que**
- la propagation de lumière dans le collimateur de lumière à facettes (2) est fondée sur la réflexion interne totale ou la réflexion au niveau d'un revêtement réfléchissant prévu sur les facettes du collimateur de lumière à facettes (2), et
- le nombre de facettes du collimateur de lumière à facettes (2) ou du réflecteur de lumière à facettes (3) double à partir d'un côté orienté vers les émetteurs de lumière vers un côté orienté dans une direction opposée aux émetteurs de lumière.

2. Système d'éclairage selon la revendication 1, dans lequel les émetteurs de lumière (R, G, B) sont agencés dans la source lumineuse (1) de sorte que les couleurs primaires soient distribuées symétriquement de façon sensiblement rotative par rapport à un plan fictif normal à l'axe longitudinal (25).

3. Système d'éclairage selon la revendication 1 ou 2, dans lequel le collimateur de lumière à facettes (2) est fait d'un matériau diélectrique avec un indice de réfraction supérieur ou égal à 1,3.

4. Système d'éclairage selon la revendication 1 ou 2, dans lequel le nombre de facettes circonférentielles du collimateur de lumière à facettes (2), pris de façon normale à l'axe longitudinal (25) sur un côté orienté vers les émetteurs de lumière (R, G, B) est entre 4 et 10.

5. Système d'éclairage selon la revendication 4, dans lequel le collimateur de lumière à facettes (2) possède une section transversale hexagonale ou octogonale, pris de façon normale à l'axe longitudinal (25) sur un côté orienté vers les émetteurs de lumière (R, G, B).

6. Système d'éclairage selon la revendication 1 ou 2, dans lequel les facettes du collimateur de lumière à facettes (2) sont pourvues d'un revêtement réfléchissant.

7. Système d'éclairage selon la revendication 1 ou 2, dans lequel le collimateur de lumière à facettes (2) comprend des facettes trapézoïdales linéaires contiguës.

8. Système d'éclairage selon la revendication 1 ou 2, dans lequel le collimateur de lumière à facettes (2) est pourvu de cavités pour loger les émetteurs de lumière (R, G, B), les cavités étant pourvues d'un encapsulant correspondant sensiblement à l'indice de réfraction du collimateur de lumière à facettes (2).

9. Système d'éclairage selon la revendication 1 ou 2, dans lequel le réflecteur de lumière à facettes (3) comprend des facettes trapézoïdales linéaires contiguës.

10. Système d'éclairage selon la revendication 1 ou 2, dans lequel le diffuseur de mise en forme de lumière (17) est prévu à une distance de la source lumineuse (1), la distance étant au moins deux fois le diamètre effectif de la source lumineuse (1).

11. Système d'éclairage selon la revendication 9, dans lequel le diffuseur de mise en forme de lumière (17) est prévu au niveau d'une fenêtre de sortie (4) du collimateur de lumière à facettes (2) ou au niveau d'une fenêtre de sortie du réflecteur de lumière à facettes (3).

12. Système d'éclairage selon la revendication 10, dans lequel le diffuseur de mise en forme de lumière (17) est un diffuseur holographique.

13. Système d'éclairage selon la revendication 1 ou 2, dans lequel les émetteurs de lumière comprennent en outre au moins une troisième diode électroluminescente (B) d'une troisième couleur primaire, les trois couleurs primaires étant distinctes les unes des autres.

14. Système d'éclairage selon la revendication 1 ou 2, dans lequel chacune des diodes électroluminescentes (R, G, B) possède un rendement d'énergie rayonnante d'au moins 25 mW lorsqu'elle est excitée à une puissance nominale et à une température ambiante.
